# EUROPEAN PATENT APPLICATION

(11) **EP 2 355 634 A1**
(43) Date of publication of application: **10.08.2011**
(21) Application number: 11152036.7
(22) Date of filing: 25.01.2011
(51) Int. Cl.: H05K 3/36

(54) **Method for connection of flexible circuit boards to rigid circuit board, device for connection thereof, printed circuit board assembly, and electronic apparatus**

(30) Priority: 29.01.2010 JP 2010019032
(71) Applicant: Fujitsu Limited, Kawasaki-shi, Kanagawa 211-8588 (JP)
(72) Inventor: Mishiro, Kinuko, Kawasaki-shi Kanagawa 211-8588 (JP)
(74) Representative: Stebbing, Timothy Charles

(57) **Abstract**

A method for connection of a flexible circuit board (220) to a rigid circuit board (210) is provided. The method includes supplying an adhesive agent onto a first electrode pattern (213) provided on one surface of the rigid circuit board (210). The rigid circuit board has a plurality of electronic components mounted on the other surface with a gap therebetween. The method also includes aligning a second electrode pattern (223), provided on the flexible circuit board (220), to the first electrode pattern of the rigid circuit board. The adhesive agent is heated under pressure to electrically connect the second electrode pattern to the first electrode pattern by pressing the gap between the plurality of electronic components with a jig (510, 520) which has a press-contact section (522) of a narrower width than the gap.

## Description

This application is based upon and claims the benefit of priority of Japanese Patent Application No. 2010-19032, filed on January 29, 2010.

The present invention relates to a method for connection of a flexible circuit board to a rigid circuit board, a device for connection thereof, a printed circuit board assembly, and an electronic apparatus.

In recent years, mobile electronic devices represented by mobile phones, digital cameras, and so on have been widely available. These mobile devices have various functional modules, such as a communication element, a liquid crystal element, or an imaging device. The functional module may be directly mounted on a printed circuit board (mother board) in the inside of the device. In some cases in the field of mobile devices, the functional module is mounted on another printed circuit board (daughter board) and then connected to the mother board.

Examples of the daughter board include a flexible printed circuit board and a rigid printed circuit board. In some cases, the daughter board is connected to the mother board through a flexible connection cable. For example, if the daughter board is formed of a flexible printed circuit board as described above, the flexible printed circuit board is directly extended to the mother board. Then, the flexible printed circuit board is fitted into a connector on the mother board. Alternatively, if a daughter board is formed of a rigid printed circuit board, a flexible connection cable may be connected to the daughter board and the mother board through connectors which are mounted on the respective daughter and mother boards.

In recent years, however, the trend of many mobile devices toward slimmer designs is rapidly progressing. The height of the above-described connector may be likely to prevent a reduction in thickness of the mobile devices. On the other hand, if the thickness of the connector is severely reduced in order to make a slim mobile device, a sufficient connection between the flexible connection cable and the connector may not be possible due to reduced strength of the fitting. Therefore, there is a limit in thickness reduction of the connector. As an alternative method to the use of such a connector, the flexible printed circuit board and the printed circuit board may be directly connected using an adhesive agent without a connector.

In this method, electrode patterns are respectively formed on two printed circuit boards to be connected to each other to allow current flow between the wiring of one printed circuit board and the wiring of the other printed circuit board. The electrode pattern includes the arrangement of a plurality of conductor patterns corresponding to the respective wiring lines to be conducted. The conductor patterns included in the respective electrode patterns are overlapped with each other through the adhesive agent between these two printed circuit boards. Subsequently, the adhesive agent is hardened to adhere and fix these two printed circuit board together. In this case, these two printed circuit boards are sandwiched between two jigs and then pressed, while allowing the adhesive agent to be hardened. As a result, the conductor pattern on one printed circuit board is electrically conducted to the conductor pattern on the other printed circuit board in a one-on-one relationship.

Furthermore, in order to further ensure an electrical connection between the conductor patterns, a connection method using an anisotropically conductive adhesive agent is disclosed in JP-A-9-331143, JP-A-2002-63958, JP-A-2004-87940, and JP-A-2007-88128, for example. The anisotropically conductive adhesive agent can exert conductivity in the direction crossing the adhesive surface due to dispersion of fine particles (conductive particles) ofNi and solder (see, for example, JP-A-2007-81198 and JP-A-2008-140718).

As one kind of the anisotropically conducive adhesive agent, an anisotropic conductive film (ACF) or the like has been known; the ACF includes dispersed conductive particles as described above in a resin film which is adhesive and can be hardened. In addition, an adhesive agent in which conductive particles are dispersed in a pasty adhesive agent has also been known as another kind of anisotropically conductive adhesive agent. In the connection method using any of these anisotropically conductive adhesive agents, the above conductive particles are sandwiched between mutually-opposing conductor patterns and are in contact with each of the conductor patterns to allow the conductor patterns to be electrically connected to each other.

The connection method using the anisotropically conductive adhesive agent allows the connected section to have a thickness of approximately several micrometers to about 10 micrometers. In addition, the conductive particles in the anisotropically conductive adhesive agent are fine conductive particles of approximately several micrometers in size. Then, conduction between the conductor patterns is performed by the conductive particles having such particle sizes, so that the connection of a high density conductor pattern is arranged at a spacing of 0.2 mm pitch or less.

In this way, the method for connection of printed circuit boards using an adhesive agent dramatically contributes to a reduction in thickness of a printed circuit board assembly, but it may often require a larger area on the printed circuit board.

In recent years, for example, the above function modules have become more sophisticated. The flexible printed circuit board to be connected to the printed circuit board may have an electrode pattern with 100 or more conductive patterns. In this case, it is necessary to provide the printed circuit board with an electrode pattern with 100 or more conductive patterns corresponding to the conductive patterns of the flexible cable. Furthermore, in many cases, the formation of such an electrode pattern with a plurality of conductor patterns requires an area of more than 20 mm in width. Also, in the printed circuit board, an area for routing wiring to the conductor patterns in the electrode pattern can be arranged around the electrode pattern.

Furthermore, when soldering is employed to mount an electronic component on the same surface as one on which the electrode pattern is formed, in many cases, there is a need of keeping the component-mounting position at a distance of about 2 mm from the electrode pattern to prevent solder from being dispersed when mounting the component. In addition, if a thermosetting adhesive agent is used, there is a need to keep the component-mounting position at a distance of about 2 mm from the electrode pattern to prevent the component from being damaged when curing.

Therefore, in many cases, the connection between the printed circuit boards using the adhesive agent restricts the area on which an electronic component can be mounted on the same surface as one on which the electrode pattern is formed. This is because there is an electrode-pattern forming area that tends to extend as described above. In addition, there is an area on which a component cannot be mounted on the periphery of the electrode pattern. Therefore, an electronic component may be mounted on the back side (reverse side) of the printed circuit board, which is opposite to the electrode-pattern forming surface.

Here, as described above, the connection between the printed circuit boards using the adhesive agent requires a process of pressing the printed circuit boards where the conductor patterns are overlapped with one another using the jigs that clamp the printed circuit boards. In this case, if an electronic component is mounted on the connected location of the printed circuit board or in the area corresponding to the back side of the electrode pattern, the jig may destroy the electronic component during pressing.

To prevent such destruction, for example, an electronic component may be mounted on the back side of a printed circuit board as described above, after the connection of printed circuit boards. In addition, an electronic component may be mounted on the back side opposite to the connection location of a printed circuit board. A component-mounting area which includes such an electronic component is then fixed using a mold agent. In this way, the printed circuit boards are pressed by the jigs when connecting the printed circuit boards.

However, when an electronic component is mounted using reflow, the technology of mounting the electronic component on the back side after connection between the printed circuit boards may result in difficulty in supplying reflow solder paste because of obstructive connected printed circuit boards. Furthermore, if the above functional module to be mounted on the connected printed circuit boards is a non-heat-resistant module, such as a camera module, there is an increased risk for difficulty in executing reflow with the application of heat. In addition, when the area on the back side on which the electronic component is mounted is fixed by the molding agent, a reduction in thickness of the device is difficult due to such a molding agent.

To describe the situation where the electronic component is mounted on the back side of the location at which two printed circuit boards are connected to each other, the above description has been made using an example printed circuit board assembly where the flexible printed circuit board is connected to a rigid printed circuit board. However, such a situation is not limited to the above structure where one of the connection targets is the flexible printed circuit board. In other words, such a situation may occur as long as the printed circuit board assembly has a structure in which printed circuit boards are overlapped and connected to each other.

According to an embodiment of the invention, a method for connection of a flexible circuit board to a rigid circuit board is provided. The method includes supplying an adhesive agent onto a first electrode pattern provided on one surface of the rigid circuit board. The rigid circuit board has a plurality of electronic components mounted on the other surface with a gap therebetween. The method also includes aligning a second electrode pattern provided on the flexible circuit board to the first electrode pattern of the rigid circuit board. The adhesive agent is heated under pressure to electrically connect the second electrode pattern to the first electrode pattern by pressing the gap between the plurality of electronic components with a jig which has a press-contact location (pressing portions) of a narrower width than the gap.

It is to be understood that both the foregoing general description and the following detailed description are exemplary and explanatory, and are not restrictive of the invention.

Reference is made, by way of example only, to the accompanying drawings in which:

FIG. 1 illustrates a mobile phone corresponding to an example of the electronic device of the present invention.

Fig. 2 illustrates an example of a printed circuit board assembly according to the first embodiment;

FIGs. 3A and 3B illustrate the details of the printed circuit board assembly shown in FIG. 2.

FIG. 4 is a diagram illustrating the details of a flexible printed circuit board shown in FIG. 2 and FIG. 3;

FIGs. 5A and 5B illustrate the details of the backup plate shown in FIG. 3;

FIG. 6 is a diagram illustrating a printed circuit board assembly of a comparative example;

FIGs. 7A to 7D illustrate a flow of process in a method for connecting a printed circuit board;

FIGs. 8A and 8B illustrate a printed circuit board assembly of a second embodiment;

FIG. 9 is a schematic diagram illustrating an example of a poor connection between conductor patterns;

FIGs. 10A and 10B illustrate a printed circuit board assembly of a third embodiment;

FIG. 11 is a diagram illustrating the details of a flexible printed circuit board shown in FIG. 10;

FIGs. 12A and 12B illustrate a printed circuit board assembly of a fourth embodiment;

FIG. 13 is a diagram illustrating the details of a flexible printed circuit board shown in FIG. 12;

FIG. 14 is a diagram illustrating another example configuration of the flexible printed circuit board shown in FIG. 13;

FIG. 15 is a diagram illustrating a printed circuit board assembly of a fifth embodiment; and

FIGs. 16A and 16B illustrate a printed circuit board assembly of a sixth embodiment.

Hereinafter, embodiments of the present invention of a method for connection of printed circuit boards, a printed circuit board assembly, an electronic apparatus, and a device for connection of printed circuit boards will be described with reference to the drawings.

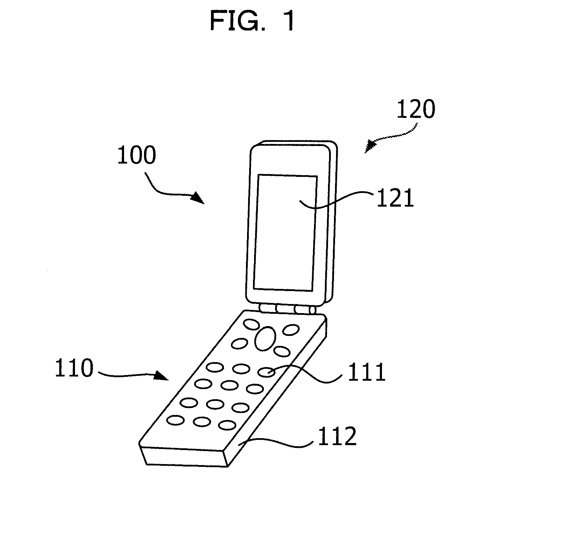

FIG. 1 illustrates a mobile phone corresponding to an example of the electronic apparatus of the present invention.

A mobile phone 100 shown in FIG. 1 includes a body part 110, a keypad 111 for various kinds of operation, and a display part 120 rotatably attached to the body part 110. The display part 120 includes a liquid crystal panel 121 on which various kinds of information can be displayed. The body part 110 includes a case in which the printed circuit board assembly is installed.

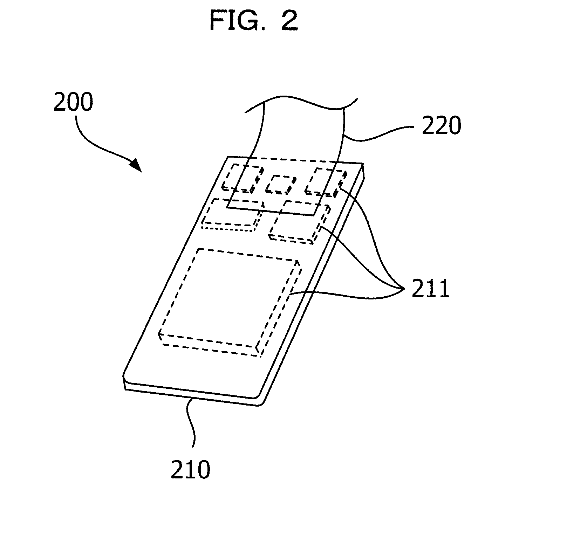

Fig. 2 illustrates an example of a printed circuit board assembly according to the first embodiment.

A printed circuit board assembly 200 shown in FIG. 2 is configured so that a flexible printed circuit board 220 on which a liquid crystal element and so on (not shown) is connected to a rigid printed circuit board 210 on which an electronic component 211 is mounted. The electronic component 211 is mounted on the back side of the rigid printed circuit board 210, which is opposite to the surface thereof to which the flexible printed circuit board 220 is connected.

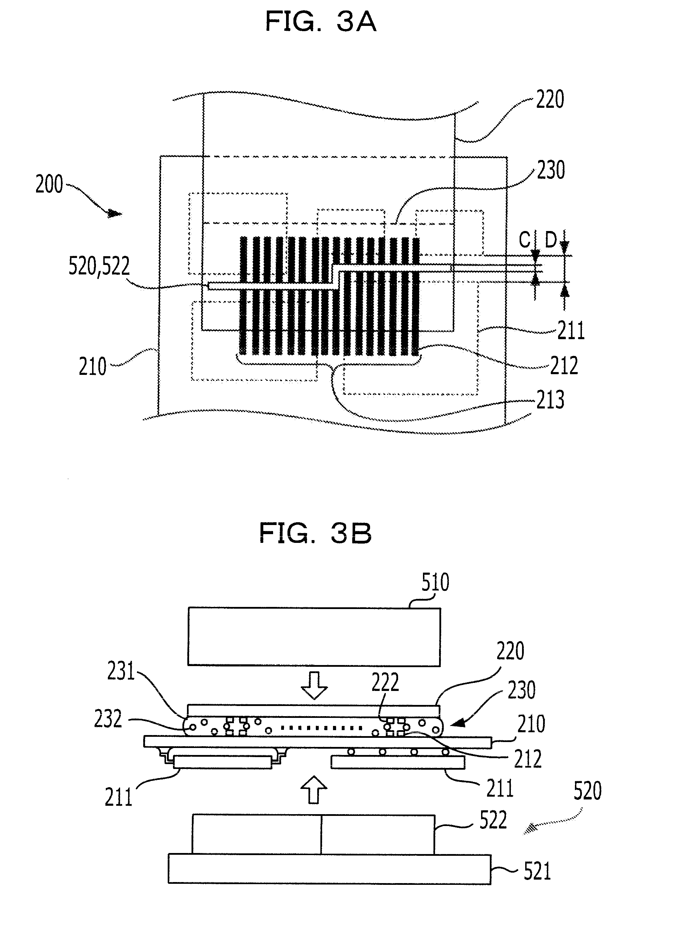

FIGs. 3A and 3B illustrate the details of the printed circuit board assembly shown in FIG. 2.

FIG. 3A is a top view of the printed circuit board assembly 200 viewed from the flexible printed circuit board 220. In addition, FIG. 3B is a side view of the printed circuit board assembly 200.

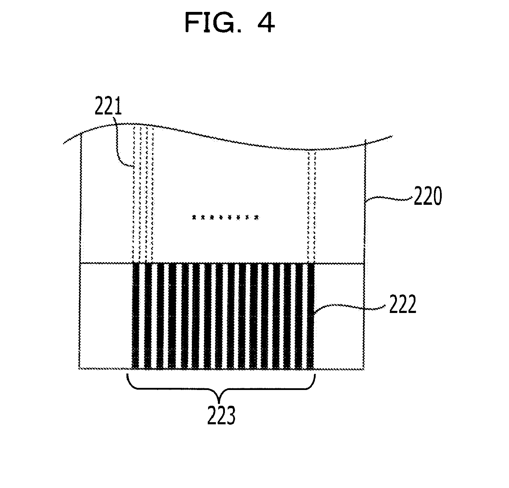

FIG. 4 is a diagram illustrating the details of the flexible printed circuit board shown in FIG. 2 and FIG. 3.

As shown in FIG. 3, a first electrode pattern 213 is formed on the surface of the rigid printed circuit board 210. The first electrode pattern 213 is constructed of a plurality of conductor patterns 212 which are linearly extended and arranged in parallel with one another. Then, the flexible printed circuit board 220 is overlapped on (positioned over) the rigid printed circuit board 210 as described below.

As shown in FIG. 4, the flexible printed circuit board 220 includes an inner layer where wiring patterns 221 are linearly extended. In other words, multiple wiring patterns 221 are arranged in parallel with one another. Then, conductor patterns 222 are formed on the surface of the flexible printed circuit board 220 and linearly extended in the direction along which each of the wiring patterns 221 extends. Here, the conductor patterns 222 are connected to the respective patterns 221 in a one-on-one relationship. Alternatively, the conductor patterns 222 may be not connected to the respective patterns 221 in a one-on-one relationship. A second electrode pattern 223 is constructed of a plurality of conductor patterns 222 arranged in the same direction as that of the arrangement of the wiring patterns 221 on the surface of the flexible printed circuit board 220.

The overlapped two printed circuit boards are bonded and fixed by an anisotropically conductive adhesive agent 230 as described below. The anisotropically conductive adhesive agent 230 allows for mutual conduction between the conductor patterns 222 of the second electrode pattern 223 and the conductor patterns 212 of the electrode pattern 213 in a one-on-one relationship.

The anisotropically conductive adhesive agent 230 distributes fine metal particles (conductive particles) 232 in a thermosetting adhesive agent 231. The conductive particles 232 allow the anisotropically conductive adhesive agent 230 to exhibit its conductivity in the direction intersecting the adhesive surface.

The thermosetting adhesive agent 231 may be a paste thermosetting adhesive agent or a resin film exhibiting adhesiveness by heat while being hardened. However, the present embodiment is not limited to such an adhesive agent. Alternatively, a thermoplastic resin may be used.

Furthermore, the conductive particles 232 may be Ni or fine solder particles, plastic particles plated with Ni or Au, or the like. In addition, the size of conductive particles 232 is in a range of about 2 to 30 µm in size. Furthermore, an appropriate size of the conductive particles 232 can be determined depending on the distance (pitch) between the adjacent conductive patterns. For example, if the pitch is 0.1 mm, the conductive particles 232 are preferably of about 5 µm in size. If the pitch is 0.5 mm the conductive particles 232 are preferably of about 20 µm in size. In the anisotropically conductive adhesive agent 230 containing the above fine Ni particles or the plated plastic particles, these particles conduct electricity by being sandwiched between the conductor patterns. In addition, the anisotropically conductive adhesive agent 230 containing fine solder particles as conductive particles 232 contributes to metallic bonding between molten solder conductor patterns and the conductive particles 232. In the present embodiment, the type or size of the conductive particles 232 is not specified.

Here, the connection between the rigid printed circuit board 210 and the flexible printed circuit board 220 using the anisotropically conductive adhesive agent 230 is performed so that two printed circuit boards are overlapped through the anisotropically conductive adhesive agent 230 while their respective conductor patterns face each other, followed by being heated and pressed. The pressing and heating may be performed using a pressing/heating plate 510 and a backup plate 520.

The pressing/heating plate 510 has a flat surface of almost the same size as the area to which the anisotropically conductive adhesive agent 230 is applied. Then, the flat surface is forced onto the backside of the second electrode pattern 223 of the flexible printed circuit board 220.

The backup plate 520 includes a flat base plate 521 as described later and a press-contact section 522 which is formed with a protrusion with respect to the flat base plate 521. In particular, the width of the press-contact section 522 is smaller than the length of the conductor patterns 212 in the first electrode pattern 213 and the length of the conductor patterns is longer than the width of the conductor patterns. The press-contact section 522 is press contacted with the back side of the first electrode pattern 213 on the rigid printed circuit board 210 so that the press-contact section 522 can intersect (coincide) with the conductor pattern 212.

Furthermore, the electronic component 211 is mounted on an area of the rigid printed circuit board 210; the area corresponds to the backside of the first electrode pattern 213. Thus, the press-contact section 522 is formed so that it can be press contacted to the location of the rigid printed circuit board 210, except for the location of the above area where the electronic component 211 is prevented from contacting with the press-contact section 522 of the backup plate 520.

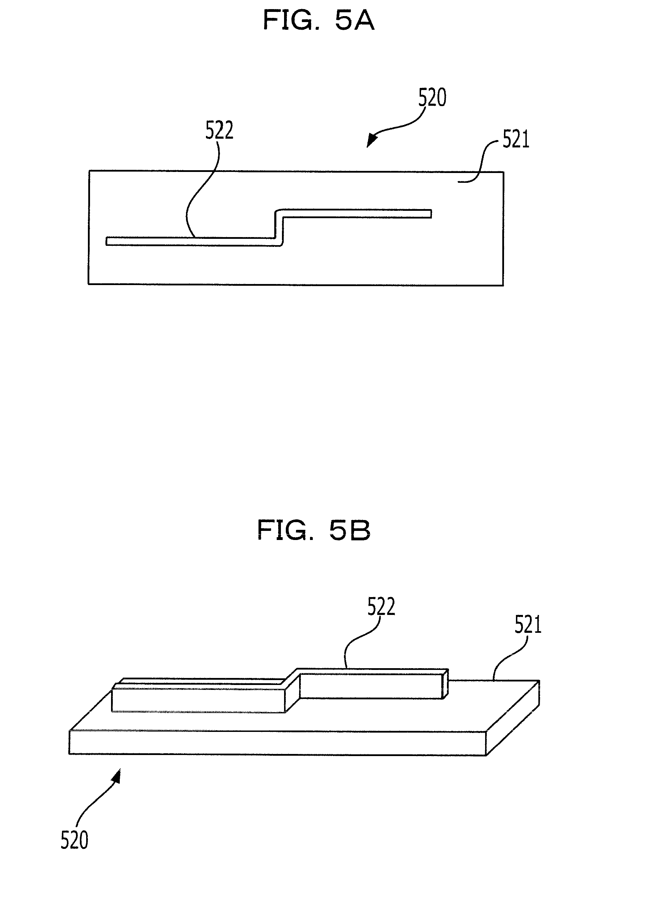

FIGs. 5A and 5B illustrate the details of the backup plate shown in FIG. 3.

FIG. 5A illustrates the top view of the backup plate 520. FIG. 5B illustrates the perspective view of the backup plate 520.

As shown in FIG. 5, the backup plate 520 includes the flat base plate 521 and the press-contact section 522. The press-contact section 522 protrudes from the base plate 521, but is shaped to avoid contact with the electronic component 211. Then, the press-contact section 522 is press-contacted to the backside of the first electrode pattern 213. The base plate 521 may be uneven, depending on the height of the electronic component 211 mounted on the rigid printed circuit board 210.

Furthermore, in the present embodiment, on the area corresponding to the backside of the first electrode pattern 213, a location facing the electronic component 211 is provided with a surface precisely flattened by the application of resist so that the press-contact section 522 can be uniformly press-contacted to such a surface. Alternatively, a press-contact area with uniform height may be formed without formation of the resist.

In the present embodiment, the rigid printed circuit board 210 and the flexible printed circuit board 220, which overlap each other through the anisotropically conductive adhesive agent 230, is held between the backup plate 520 and the pressing/heating plate 510 as described above. Then, in this state, pressure is applied to the rigid printed circuit board 210 and the flexible printed circuit board 220 by the pressing/heating plate 510. Furthermore, the anisotropically conductive adhesive agent 230 is hardened by heat applied from the pressing/heating plate 510 through the flexible printed circuit board 220. Therefore, the anisotropically conductive adhesive agent 230 can be hardened while the pressure from the pressing/heating plate 510 is concentrated on the section of the backup plate 520, to which the press-contact section 522 is press-contacted, and the surrounding area. As a result, as shown in FIG. 3B, on the pressure-concentrated location, the conductive particles 232 can be securely captured between the conductor patterns 222 of the second electrode pattern 223 and the conductor patterns 212 of the first electrode pattern 213. In this case, such pressure-concentrated section receives a sufficient amount of heat for firm hardening of the anisotropically conductive adhesive agent 230, enough to withstand the time degradation of (give long-term stability to) the adhesive agent 230. Since the conductive particles 232 are appropriately captured by sufficient pressure and heat as described above, the conductor patterns 212 of the first electrode pattern 213 and the conductor patterns 222 of the second electrode pattern 223 can be electrically conductive to each other.

In the present embodiment, the anisotropically conductive adhesive agent 230 has been described as an example of the adhesive agent. However, the adhesive agent is not limited to the anisotropically conductive adhesive agent 230. In addition, the above pressing allows the conductor patterns 222 of the second electrode pattern 223 and the conductor patterns 212 of the first electrode pattern 213 to be directly contacted to each other at the pressure-concentrated section. Then, as a result of the contact, these conductor patterns 212 and 222 can be electrically conductive to each other.

On the rigid printed circuit board 210, the conductor patterns 212 of the first electrode pattern 213 have a length of preferably 2 to 4 mm.

Between the conductor patterns 212 2 of the first electrode pattern 213 and the conductor patterns 222 of the second electrode pattern 223, the conductive particles 232 may be also captured on the section other than the above pressure-concentrated section, even though the level of certainty of the capture decreases. Therefore, if the conductor patterns 212 are formed too short for the purpose of saving space on the rigid printed circuit board 210, the number of the conductive particles 232 captured between the conductive patterns becomes insufficient. In addition, if a simple adhesive agent that does not contain the conductive particles as described above is used, the lengths of the sections of the respective conductor patterns, which are directly contacted to each other, can be shortened. Furthermore, the application of the anisotropically conductive adhesive agent 230 to the rigid printed circuit board 210 is performed within the bounds of covering the first electrode pattern 213. Thus, the coated area of the rigid printed circuit board 210 influences the adhesive strength of the flexible printed circuit board assembly 220 to the rigid printed circuit board 210. Therefore, the area to which the anisotropically conductive adhesive agent 230 is applied is small if the conductor patterns 212 of the first electrode pattern 213 are too short, resulting in a decrease in adhesive strength. In consideration of these facts, the present embodiment employs a length of 2 to 4 mm as a preferable length of the conductor patterns 212 as described above.

Here, a printed circuit board assembly of a comparative example will be described for comparing with the printed circuit board assembly 200 of the present embodiment.

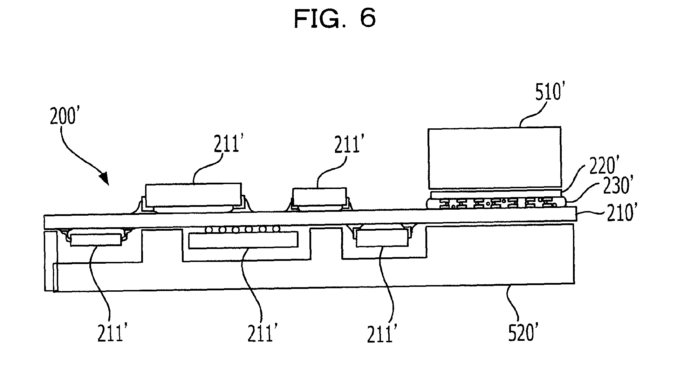

FIG. 6 is a diagram illustrating a printed circuit board assembly of a comparative example.

FIG. 6 illustrates a printed circuit board assembly 200' of the comparative example together with a pressing/heating plate 510' and a backup plate 520' for connecting a flexible printed circuit board 220' to a rigid printed circuit board 210' using an anisotropically conductive adhesive agent 230'.

In this printed circuit board assembly 200' of the comparative example, unlike the printed circuit board assembly 200 of the above embodiment, the connection between the conductor patterns is performed by pressing and heating the entire area coated with the anisotropically conductive adhesive agent 230'. Thus, the back plate 520' of the comparative example uniformly presses the entire backside of the connected location of the flexible printed circuit board 220'. In this comparative example, two printed circuit boards are connected under the concept that pressure and heating on the entire area coated with the anisotropically conductive adhesive agent 230' are essential for the reliable electrical connection between the conductor patterns using the anisotropically conductive adhesive agent 230'.

In addition, in the printed circuit board assembly 200' of the comparative example, the electronic components 211' are mounted on both sides of the rigid printed circuit board 210'. Furthermore, on the backside of the electronic components 211', the mounting of the electronic component 211' on the backside of the connected location of the flexible printed circuit board 220 to prevent the electric component 211' from being broken by pressing and heating by the pressing/heating plate 510' and the backup plate 520' as described above. Furthermore, on the surface of the rigid printed circuit board 210', the mounting of the electronic component 211' on the area within about 2 mm from the conductor patterns to avoid scattering of solder when mounting the component and damaging of the electronic component 211' when heating.

Therefore, in the printed circuit board assembly 200' of the comparative example, the mount areas for the electronic components 211' on the both sides of the rigid printed circuit board 210' are restricted due to the connection of the flexible printed circuit board 220'. As a result, the packaging density of electronic components 211' in the printed circuit board assembly 200' of a comparative example is lower than that of the above embodiment.

According to the present embodiment, in order to conduct local pressing, the backside of the connected location is locally pressed by the press-contact section 522. Therefore, the electronic component 211 can be mounted on the location which is not subjected to the pressure at the time of pressing. In other words, such a place is located on the backside of the connected location and located away from the location where the press-contact section 522 is press-contacted. Thus, in the printed circuit board assembly 200 of the present embodiment, the electronic components 211 can be mounted on the backside of the connected location of the flexible printed circuit board 220.

Furthermore, in the printed circuit board assembly 200 of this embodiment, the press-contact section 522, which has a width narrower than the length of the conductor patterns as described above, touches the backside of the rigid printed circuit board 210 when connecting to the flexible printed circuit board 220. Therefore, it is possible to suppress the rate of heat that has escaped to the backup plate 520 from the total amount of heat applied from the pressing/heating plate 510 at the time of the above connection. As a result, the anisotropically conductive adhesive agent 230 can be efficiently heated and hardened. Thus, an efficient employment of setting the temperature of heating by the pressing/heating plate 510 is also possible.

In the printed circuit board assembly 200 of the present embodiment, the connection of the flexible printed circuit board 220 to the rigid printed circuit board 210 is performed using the anisotropically conductive adhesive agent 230 in which the conductive particles are dispersed. Therefore, in the printed circuit board assembly 200 of this embodiment, the conductor patterns 212 of the rigid circuit board 210 and the conductor patterns 222 of the flexible printed circuit board 220 can be electrically conducted to each other without fault.

Thus, on the backside of the rigid printed circuit board 210 in the printed circuit board assembly 200, the press-contact section 522 is press-contacted to a location away fromof the location on which the electronic component 211 is mounted in the area corresponding to the backside of the first electrode pattern 213. Therefore, in the printed circuit board assembly 200 of this embodiment, the high density assembly of electronic components 211 can be realized.

Thus, the above printed circuit boards are pressed by the above mentioned jigs at a location away from the location on which the electronic component is mounted in the region corresponding to the backside of the first electrode pattern.

Next, a method for connecting a printed circuit board will be described.

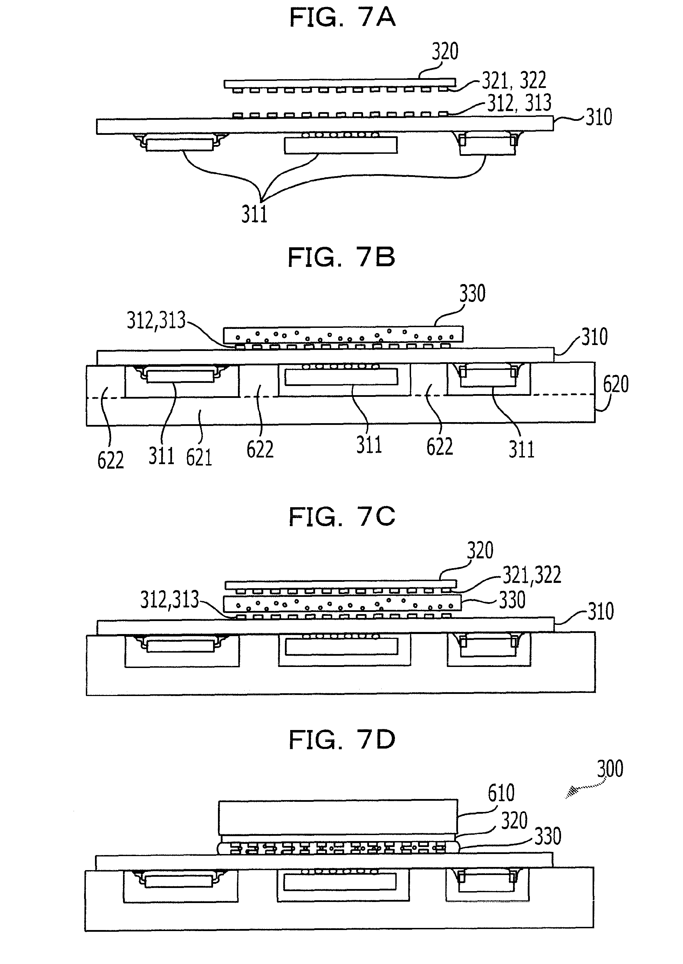

FIGs. 7A to 7D illustrate a flow of process in a method for connecting a printed circuit board.

Furthermore, in FIGs. 7A to 7D, the flow of the process in the method for connecting the printed circuit board is illustrated using a schematic configuration of a printed circuit board assembly 300 as an example, which is different from the printed circuit board assembly 200 installed in the mobile phone 100 as shown in FIG. 3 with respect to the arrangement of components, the sizes of the printed circuit boards, and so on. Also, in FIG. 7, an example of the embodiment of the device for connection of printed circuit boards for performing a method for connecting the printed circuit boards is also illustrated.

In Fig. 7A, a printed circuit board 310 and a flexible printed circuit board 320 are prepared.

Like the rigid printed circuit board 210 shown in FIG. 3, a first electrode pattern 313 is formed on a printed circuit board 310. The first electrode pattern 313 is constructed of a plurality of conductive patterns 312 which are linearly extended and arranged in parallel with one another. In addition, electronic components 311 are mounted on two or more locations on the backside of the printed circuit board 310, including the backside of the first electrode pattern 313.

Then, like the flexible printed circuit board 220 of FIG. 3, a second electrode pattern 322 corresponding to the first electrode pattern 313 of the first electrode pattern 313 of the printed circuit board 310 is formed on the flexible printed circuit board 320. The second electrode pattern 322 includes a plurality of conductive patterns 322 which are arranged in parallel with one another.

In Fig. 7B, the above printed circuit board 310 is mounted on the backup plate 620. Like the backup plate 520 of FIG. 5, the backup plate 620 includes a flat base plate 621 and a press-contact section 622 which is pressed on the backside of the printed circuit board 310 so as to thread through the electronic components 311. In FIG. 7B, the press-contact section 622 appears as if it is only present between the electronic components 311. However, this is illustrated as a matter of convenience. The illustrated sections of the press-contact section 622 are connected to one another in the depth direction of the drawing.

In Fig. 7B, an anisotropically conductive adhesive agent 230, which is equivalent to the anisotropically conductive adhesive agent 230 used in the printed circuit board assembly 200 shown in FIG. 3, is applied to the location of the printed circuit board assembly 310 on which the first electrode pattern 313 is formed.

Here, if the anisotropically conductive adhesive agent 330 is one in which conductive particles are dispersed in a thermosetting resin film, for example, the processing in Fig. 7B may be performed under the following conditions: If the thickness of the film-shaped anisotropically conductive adhesive agent 330 is about 40 µm, for example, the anisotropically conductive adhesive agent 330 is pressed against the printed circuit board 310 at a pressure of about 1 MPa and heated at a temperature of 50 to 80°C for about one second. On the other hand, if the anisotropically conductive adhesive agent 330 is in the type of dispersing conductive particles in a paste adhesive agent, the application of the anisotropically conductive adhesive agent 330 is performed by dropping it onto the printed circuit board 310. Furthermore, the thickness of the film-shaped anisotropically conductive adhesive agent 330 and the amount of the paste anisotropically conductive adhesive agent 330 dropped are determined from their respective amounts prefered to fill the gap between the adjacent conductor patterns on each of the printed circuit boards. This prefered amount may be calculated from the height of the conductor patterns 312 of the printed circuit board 310, and the height of the conductor patterns 321 of the flexible printed circuit board 320.

In Fig. 7C, the flexible printed circuit board 320 is mounted through the above anisotropically conductive adhesive agent 330. The processing in Fig. 7C is performed while the conductor patterns 321 of the flexible printed circuit board 320 are precisely aligned to the respective conductor patterns 312 of the printed circuit board 310 in a one-on-one relationship. Furthermore, the process of Fig. 7C is performed under the same conditions as that in Fig. 7B as described above.

In Fig. 7D, a pressing/heating plate 610 is brought down on the flexible printed circuit board 320. Then, the pressure and the heat depending on the hardening conditions of the anisotropically conductive adhesive agent 330 are applied to the flexible printed circuit board 320 from above for a predetermined time. The pressure may vary depending on the viscosity of the adhesive agent or the resin film at the time of melting, the presence or absence of conductive particles, and the material and shape of particles if the conductive particles are present. However, a preferable pressure is in the range of 1 to 10 MPa. In particular, if there are no conductive particles, higher pressure may be necessary in many cases. Furthermore, the heating temperature is preferably in the range of about 180 to 220°C if the adhesive agent or the resin film is made of epoxy resin or preferably in the range of about 120 to 200°C if it is made of acrylic resin. The period of time for applying pressure or heat is preferably in the range of about 10 to 20 seconds if the adhesive agent or the resin film is made of epoxy resin or preferably in the range of about 5 to 12 seconds if it is made of acrylic resin.

Here, the anisotropically conductive adhesive agent 330 used in the present embodiment is one having thermosetting properties. The heating for hardening the anisotropically conductive adhesive agent 330 is performed using the pressing/heating plate 610 having a press surface of substantially the same size as that of the area to which the anisotropically conductive adhesive agent 330 is applied. The heat generated when heating tends to escape to the backup plate 620. However, the backup plate 620 is only locally in contact with the printed circuit board 310, so that the escape of the heat can be restricted. As a result, the hardening by efficient heating of the anisotropically conductive adhesive agent 330 can be performed, so that efficient employment of the pressing/heating plate 610, such as the setting of the pressing/heating plate 610 to a low heating temperature, is possible.

The process of connecting between the first printed circuit board and the second printed circuit board corresponds to the process of hardening the adhesive agent by heating the adhesive agent through the second printed circuit board assembly.

In the present embodiment, the processing in Fig. 7A prepares the rigid printed circuit board 310 and the flexible printed circuit board 320, which are different in rigidity, as two printed circuit boards to be connected to each other. Then, in the process of Fig. 7D, the rigid printed circuit board 310 which has higher rigidity than the flexible printed circuit board 320 is pressed by the narrow press-contact section 622. In other words, among these two printed circuit boards, the rigid printed circuit board, which can sufficiently withstand the local press as described above, can be pressed by the narrow press-contact section 622 because of its comparatively higher rigidity. Therefore, in the present embodiment, it is possible to perform the local pressing as described above while helping toprevent the printed circuit boards from being damaged.

In the present embodiment, the first printed circuit board and the second printed circuit board have different rigidities, respectively. In addition, the processing for connecting the first printed circuit board and the second printed circuit board to each other includes pressing one that has comparatively higher rigidity among the first printed circuit board and the second printed circuit board.

The rigid printed circuit board 210 and the flexible printed circuit board 220 shown in FIG. 3 and the printed circuit board 310 and the flexible printed circuit board 320 shown in FIG. 7 may correspond to an example of the first printed circuit board and the second printed circuit board in this applied configuration. The processing in FIG. 7D also corresponds to an example of the processing for connecting the first printed circuit board and the second printed circuit board to each other in this applied configuration.

As described above with reference to FIG. 3 and so on, the use of the method for connection of printed circuit boards can obtain a printed circuit board assembly on which electronic components are mounted on the backside of the connection location of a printed circuit board assembly without difficulty.

Next, a second embodiment will be described.

In this embodiment, the configurations of a printed circuit board assembly, and a press-contact section of the backup plate used in a method for connection of printed circuit boards, are different from those of the above first embodiment. On the other hand, a mobile phone on which the printed circuit board assembly is mounted and the flow of processing in the method for connection of printed circuit boards are the same or similar to those of the above first embodiment, respectively. In the following description, the explanation about the mobile phone and the method for connection of printed circuit boards will be omitted, while particular attention will be directed toward the above differences.

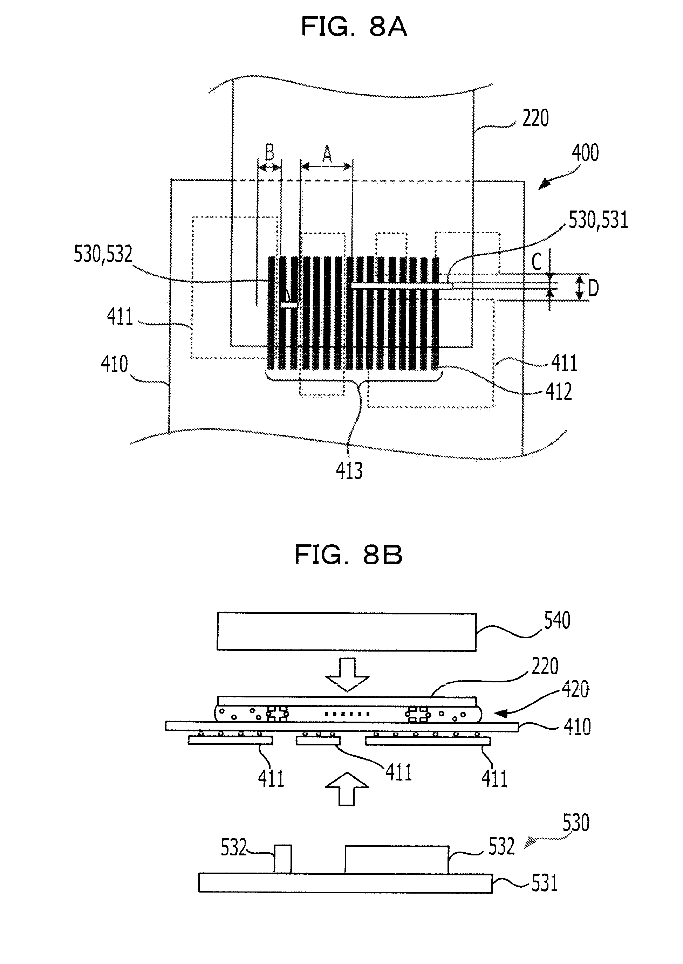

FIGs. 8A and 8B illustrate a printed circuit board assembly of a second embodiment.

In a printed circuit board assembly 400 shown in FIG. 8A, the configuration and size of each electronic component 411 mounted on a printed circuit board 410, as well as the arrangement thereof on the printed circuit board 410, are different from those of the printed circuit board assembly 200 of the first embodiment shown in FIG. 3. In contrast, a flexible printed circuit board of the second embodiment is the same or similar to the flexible printed circuit board 220 of FIG. 3. Thus, hereinafter, the flexible printed circuit board of the second embodiment will be marked with the same reference numeral, 220, as shown in FIG. 3 to omit the duplicated description.

FIG. 8A is a top view of the printed circuit board assembly 400 viewed from the flexible printed circuit board 220. In addition, FIG. 8B is a side view of the printed circuit board assembly 400.

The backup plate 530 includes a flat base plate 531 and a press-contact section 532. The press-contact section 532 is projected from the base plate 531 and press-contacted to the backside of the first electrode pattern 413, while avoiding touching the above electronic component 411.

Here, on the backup plate 530, two press-contact sections 532 are formed with a predetermined distance. In particular, the width of the press-contact section 532 is smaller than the length of the conductor patterns 412 in the first electrode pattern 413 and the length thereof is longer than the width of the conductor patterns.

In addition, among these two press-contact sections 532, the left end of the press-contact section 532 on the left side of the figure is located rightward from the left end of the first electrode pattern 413. In other words, in the present embodiment, the press-contact section 532 does not cross the conductor patterns 412 between two press-contact sections 532 and the conductor patterns 412 located leftward from the press-contact section 532 on the left side of the figure.

In the present embodiment, the connection of the flexible printed circuit board 220 to the printed circuit board 410 is performed by pressing and heating these printed circuit boards overlapped with each other through an anisotropically conductive adhesive agent 420. Here, the pressing and heating are performed by sandwiching and pinching the flexible printed circuit board 220 and the printed circuit board 410 by the backup plate 530 and the pressing/heating plate 540. In the present embodiment, the above conductor patterns 412 on the above two printed circuit boards, which are not crossed by the press-contact section 532, are not pinched in such a manner.

Here, if the distance A between two press-contact sections 532 is 4 mm or less, the conductor patterns between two press-contact sections 532 can be appropriately connected to each other. In addition, if the distance B from the end of the press-contact section 532 to the left end of the conductor patterns 412 is not more than 2 mm, the conductor patterns 412 located on the area away from the press-contact section 532 can be also appropriately connected.

Here, in this embodiment, on condition that the distance A between the press-contact sections 532 is adjusted to not more than 4 mm, the backup plate 430 may have two or more press-contact sections 532 of the backup plate 530. As a result, as shown in FIG. 8, the electronic component 411 can even be mounted between these press-contact sections 532. Therefore, in the present embodiment, the electronic component 411 can be mounted on the back surface of the printed circuit board 410 with high flexibility.

The gaps between a plurality of electronic components mounted on one side of the above first printed circuit board are pressed by a plurality of press surfaces arranged at predetermined intervals.

Like the above first embodiment, it is noted that the second embodiment described above is able to mount the electronic component 411 on the backside of the location of the printed circuit board 410, to which the flexible printed circuit board 220 is connected.

Here, to perform local pressing, each of the press-contact sections 522 and 532 in FIG. 3 and FIG. 8 has a width C of about 0.4 mm or more in the direction along which the conductor patterns extend. In addition, the distance D between the electronic components across the press-contact section of the backup plate is about 1.0 mm or more.

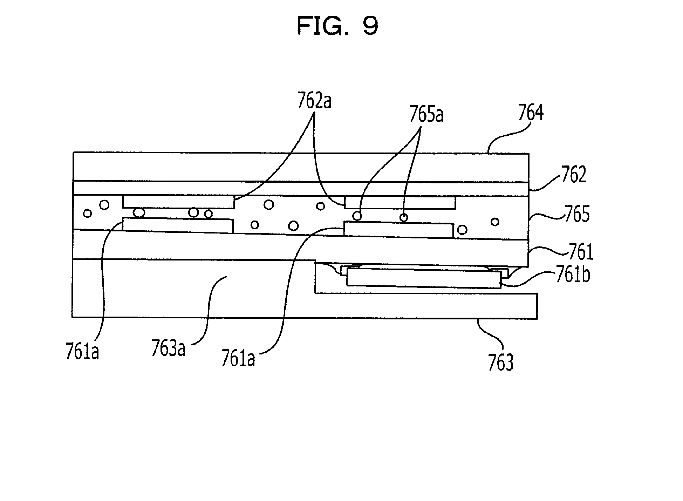

FIG. 9 is a schematic diagram illustrating an example of poor connection between conductor patterns.

FIG. 9 illustrates an enlarged view of a section with a poor connection between the conductor patterns 761a of a printed circuit board 761 and the conductor patterns 762a of a flexible printed circuit board 762 in a printed circuit board assembly 760. Furthermore, in FIG. 9, each conductor pattern is magnified and represented to facilitate visualization with respect to electronic components 761b mounted on the backside of conductor patterns 761a of the printed circuit board 761.

In an example shown in FIG. 9, two connected sections of conductor patterns are illustrated. Then, the backside of the connected section on the right side of the figure is not supported by the press-contact section 763a of the backup plate 763 to avoid the electronic component 761a mounted on the backside. Furthermore, on the connected location away from the press-contact section 763a at a distance where a connection ispossible, the gap between the conductor patterns are longer than the particle size of conductor particles 765a in an anisotropically conductive adhesive agent 765 due to insufficient pressure and heat. As a result, poor connection occurs at this connected location because of an increase in the resistance value of the connection between the conductor patterns.

Next, a third embodiment will be described.

In this third embodiment, the configurations of a printed circuit board assembly, and a press-contact section of the backup plate used in a method for connection of printed circuit boards, are different from those of the above first embodiment. On the other hand, a mobile phone on which the printed circuit board assembly is mounted and the flow of processing in the method for connection of printed circuit boards are the same as or similar to those of the above first embodiment, respectively. In the following description, therefore, the explanation about the mobile phone and the method for connection of printed circuit boards will be omitted, while particular attention will be directed toward the above differences.

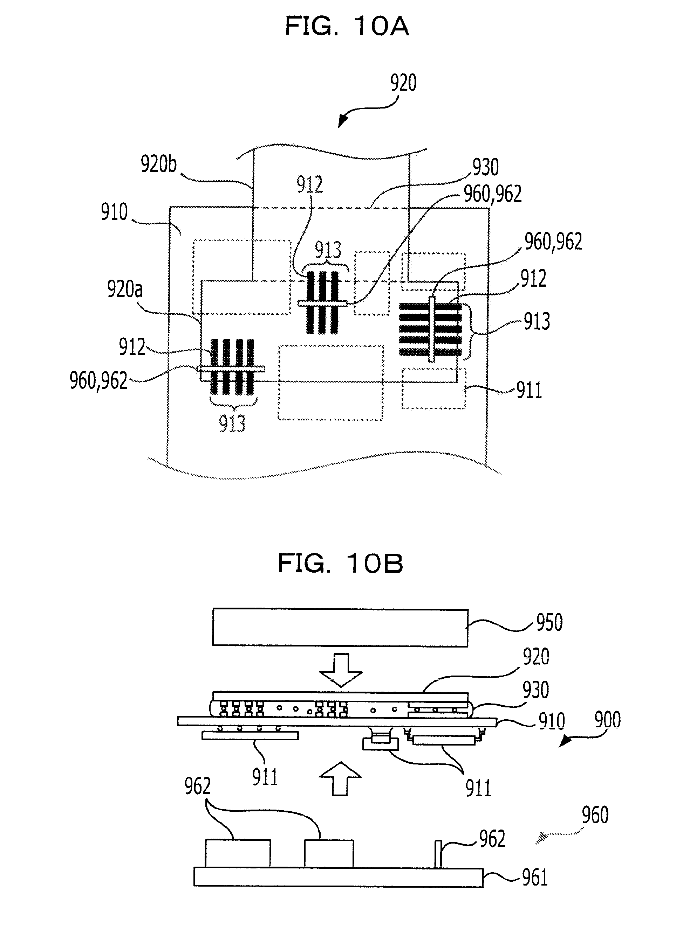

FIGs. 10A and 10B illustrate a printed circuit board assembly of a third embodiment.

In a printed circuit board assembly 900 shown in FIGs. 10A and 10B, the configuration and size of each electronic component 911 mounted on a printed circuit board 910, as well as the arrangement thereof on the printed circuit board, are different from those of the printed circuit board assembly 200 of the first embodiment shown in FIG. 3.

FIG. 10A is a top view of the printed circuit board assembly 900 viewed from the flexible printed circuit board 920. In addition, FIG. 10B is a side view of the printed circuit board assembly 900.

In the present embodiment, on the surface of the printed circuit board 910, a first electrode pattern 913 is formed on each of three sections. The first electrode pattern 913 is constructed of a plurality of conductor patterns 912 which are linearly extended and arranged in parallel with one another. Then, each of these first electrode patterns 913 is formed on the area corresponding to the space between electronic components 911 mounted on the backside of the section of the printed circuit board 910, to which the flexible printed circuit board 920 is connected.

In addition, in the present embodiment, the flexible printed circuit board 920 connected to the printed circuit board 910 includes a connected section 920a and a wiring section 920b as described below. The connected section 920a covers the coating region of the anisotropically conductive adhesive agent 930. A second electrode pattern, which will be described below, is formed on the connected section 920a. The wiring section 920b includes an inner layer where wiring patterns 221 are linearly extended.

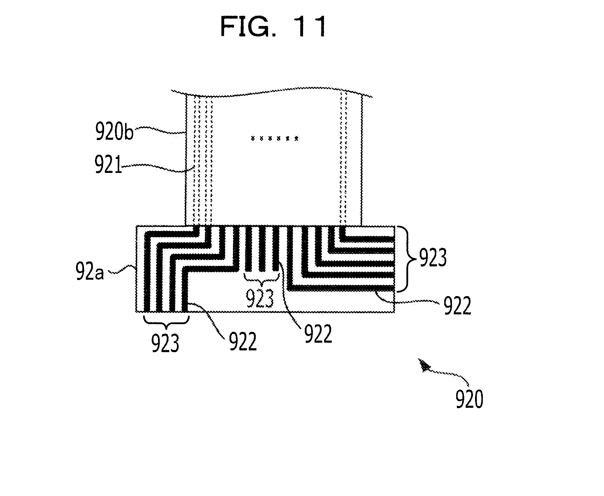

FIG. 11 is a diagram illustrating the details of a flexible printed circuit board shown in FIG. 10;

In the flexible printed circuit board 920, as described above, multiple wiring patterns 921 are arranged in parallel with one another in the inner layer of the wiring section 920b as described above. Therefore, on the surface of the connected section 920a, three second electrode patterns 923 composed of conductor patterns 922 connected to the respective wiring patterns 921 are formed. The conductor patterns 922 of each second electrode pattern 923 extend to the positions facing the respective conductor patterns 912 of each of three first electrode patterns 913 on the printed circuit board 910 shown in FIG. 10 in a one-on-one relationship.

Furthermore, in the present embodiment, a pressing/heating plate 950 and a backup plate 960 as described below are used for the connection between the printed circuit board 910 and the flexible printed circuit board 920.

The backup plate 960 includes a flat base plate 961 and three press-contact sections 962 press-contacted to the backsides of three first electrode patterns 913 of FIG. 10, respectively. Each press-contact section 962 extends in the direction along which the conductor patterns 912 of the corresponding electrode pattern 913, while not having a length long enough to contact to an electronic component 911.

When making a connection between the printed circuit board 910 and the flexible printed circuit board 920, these three press-contact sections 962 are press-contacted to the backsides of three first electrode patterns 913, respectively. Then, both the printed circuit board 910 and the flexible printed circuit board 920 are clamped and pressed by the pressing/heating plate 650 and these three press-contact sections 962. Therefore, three sets of the first electrode patterns 913 and the second electrode patterns 923 simultaneously perform the connection between the conductor patterns at three different locations, respectively.

In the present embodiment, as described above, the connection between the conductor patterns is performed at each of two or more different locations to increase the flexibility of mounting electronic components on the backside of the printed circuit board 910.

Each of the above first printed circuit board and the above second printed circuit board are constructed of electrode patterns facing each other at different positions on the surfaces of the respective printed circuit boards. In addition, the processing for connecting the first printed circuit board and the second printed circuit board to each other includes pressing from the first printed circuit board using jigs having a plurality of press surfaces corresponding to the above multiple positions.

Like the above first embodiment, it is noted that the third embodiment described above is able to mount the electronic component 911 on the backside of the location of the printed circuit board 910, to which the flexible printed circuit board 910 is connected.

Next, a fourth embodiment will be described.

In this fourth embodiment, the configurations of a printed circuit board assembly, and a press-contact section of the backup plate used in a method for connection of printed circuit boards, are different from those of the above first embodiment. On the other hand, a mobile phone on which the printed circuit board assembly is mounted and the method for connection of printed circuit boards are the same or similar to those of the above first embodiment, respectively. In the following description, the explanation about the mobile phone and the method for connection of printed circuit boards will be omitted, while particular attention will be directed toward the above differences.

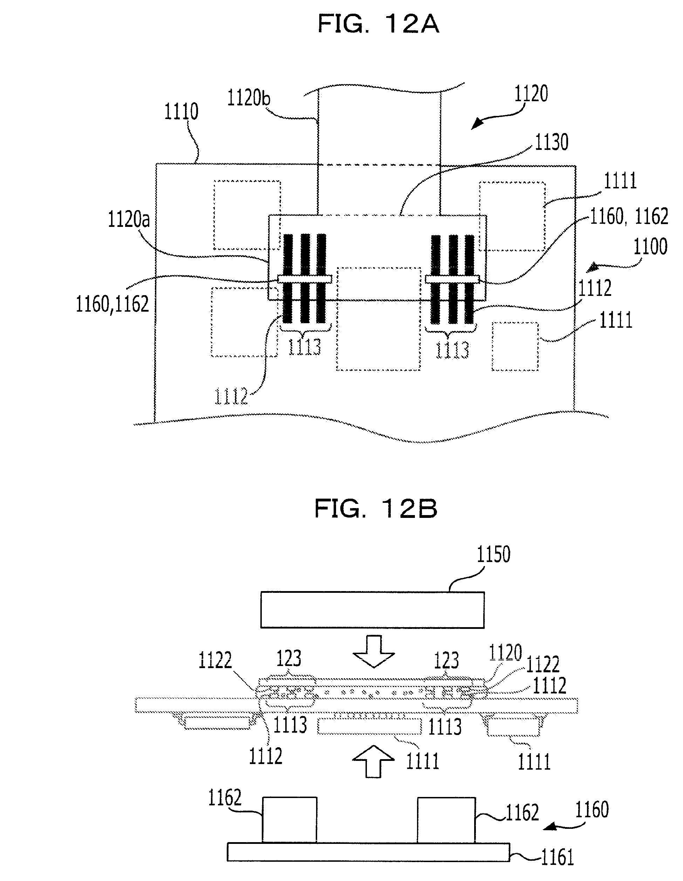

FIGs. 12A and 12B illustrate a printed circuit board assembly of a fourth embodiment;

In a printed circuit board assembly 1100 shown in FIGs. 12A and 12B, the configuration and size of each electronic component 1111 mounted on a printed circuit board 1110, as well as the arrangement thereof on the printed circuit board 1110, are different from those of the printed circuit board assembly 200 of the first embodiment shown in FIG. 3.

FIG. 12A is a top view of the printed circuit board assembly 1100 viewed from the flexible printed circuit board 1120. In addition, FIG. 12B is a side view of the printed circuit board assembly 1100.

In the present embodiment, on the surface of the printed circuit board 1110, a first electrode pattern 1113 is formed. The first electrode pattern 1113 is constructed of a plurality of conductor patterns 1112 which are linearly extended and arranged in parallel with one another. Then, a plurality of electronic components 1111 is mounted on the back surface of the printed circuit board 1110, which includes the backside of the location connected to the flexible printed circuit board 1120.

In the present embodiment, furthermore, the flexible printed circuit board 1120 covers the area coated with an anisotropically conductive adhesive agent 1130. In addition, the flexible printed circuit board 1120 includes a connection location 1120a, where a second electrode pattern is formed as described below, and a wiring section 1120, where wiring patterns linearly extend in an inner layer thereof.

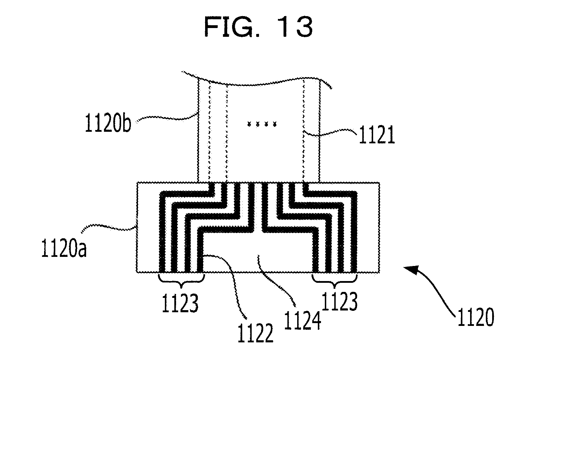

FIG. 13 is a diagram illustrating the details of the flexible printed circuit board shown in FIG. 12.

In the flexible printed circuit board 1120, as described above, multiple wiring patterns 1121 are arranged in parallel with one another in the inner layer of the wiring section 1120b as described above. Then, on the surface of the connected section 1120a, three second electrode patterns 1123 composed of conductor patterns 1122 connected to the respective wiring patterns 1121 are formed. The conductor patterns 1122 of each second electrode pattern 1123 extend to the positions facing the respective conductor patterns 1112 of each of three first electrode patterns 1113 on the printed circuit board 1110 shown in FIG. 12 in a one-on-one relationship.

Furthermore, in the present embodiment, a pressing/heating plate 1150 and a backup plate 1160 as described below are used for the connection between the printed circuit board 1110 and the flexible printed circuit board 1120.

The backup plate 1160 includes a flat base plate 1161 and two press-contact sections 1162 press-contacted to the backsides of two first electrode patterns 1113 of FIG. 12, respectively. Each press-contact section 1162 extends in the direction along which the conductor patterns 1112 of the corresponding electrode pattern 1113, while avoiding contact with an electronic component 1111.

When making a connection between the printed circuit board 1110 and the flexible printed circuit board 1120, these two press-contact sections 1162 are press-contacted to the backsides of two first electrode patterns 1113, respectively. Then, both the printed circuit board 1110 and the flexible printed circuit board 1120 are clamped and pressed by the pressing/heating plate 1150 and these three press-contact sections 1162. Therefore, two sets of the first electrode patterns 1113 and the second electrode patterns 1123 simultaneously perform the connection between the conductor patterns, respectively.

In the present embodiment, like the above third embodiment as described above, the connection between the conductor patterns is performed at each of two or more different locations to increase the flexibility of mounting electronic components on the backside of the printed circuit board.

In the present embodiment, as shown in FIG. 13, a base 1124 formed of a resin film or the like occupies an area located between two second electrode patterns 1123 on the flexible printed circuit board 1120, while the conductor patterns 1122 do not reach to such an area. In the present embodiment, the base 1124 in this area is also adhered and fixed to the printed circuit board 1110 by an anisotropically conductive adhesive agent 1130. In the present embodiment, the base 1124 in this area, which is unrelated to the connection of conductor patterns, also contributes to the connection strength of the flexible printed circuit board 1120 to the printed circuit board 1110. However, the flexible printed circuit board connected to the printed circuit board 1110 is not limited to such a configuration. Alternatively, as described below, another configuration, from which the base in the area unrelated to the connection of conductor patterns is removed, may be employed.

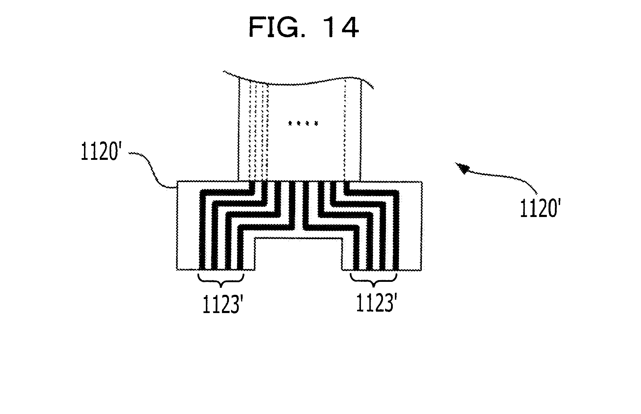

FIG. 14 is a diagram illustrating another example configuration of the flexible printed circuit board shown in FIG. 13.

In a flexible printed circuit board 1120' of another example configuration shown in FIG. 14, a base in the area unrelated to the connection of conductor patterns located between the second electrode patterns 1123 in two sections is removed. As a result, in the flexible printed circuit board 1120' of this other example configuration, a section 1120a' to which the printed circuit board 1110 of FIG. 12 is connected is formed into a bifurcated shape.

In this way, for example, the flexible printed circuit board is formed into a shape where the area related to the connection of conductor patterns remains, so that the amount of the anisotropically conductive adhesive agent used can be limited to the minimum necessary.

Like the above first embodiment, it is noted that the fourth embodiment described above is able to mount the electronic component 1111 on the backside of the location of the printed circuit board 1110, to which the flexible printed circuit board 1120 is connected.

Next, a fifth embodiment will be described.

The fifth embodiment differs from the fourth embodiment with respect to the printed circuit board assembly. On the other hand, like the fourth embodiment, a mobile phone on which the printed circuit board assembly is mounted and the method for connection of printed circuit boards are the same or similar to those of the above first embodiment, respectively. In the following description, therefore, the explanation about the mobile phone and the method for connection of printed circuit boards will be omitted, while particular attention will be directed toward the above differences.

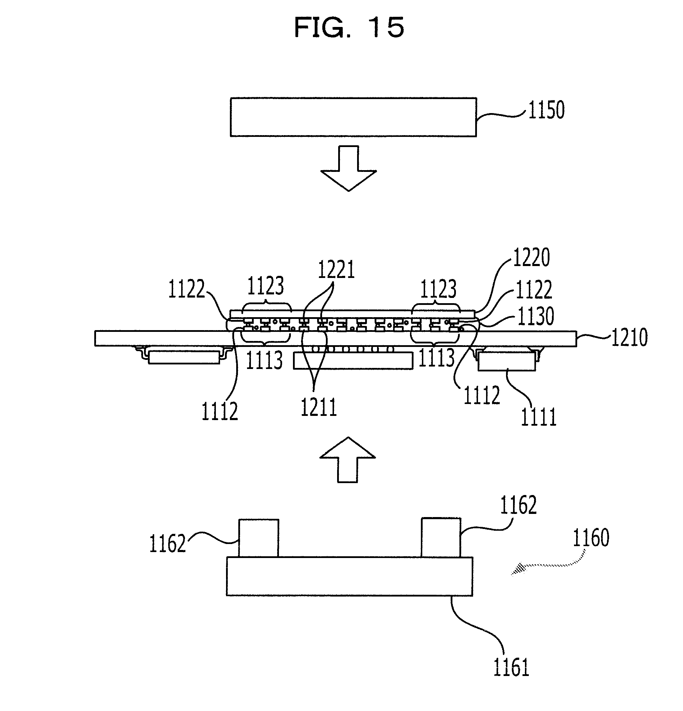

FIG. 15 is a diagram illustrating a printed circuit board assembly of the fifth embodiment.

Specifically, FIG. 15 is a side view of the printed circuit board assembly 1200.

Here, in FIG. 15, the same structural components as those in FIG. 12B, which illustrates the side view of the printed circuit board 1100 of the fourth embodiment, are designated by the same reference numerals as those of FIG. 13B. Hereinafter, duplicated description of these equivalent components will be omitted.

In this embodiment, two or more dummy patterns 1211 are arranged in parallel with one another between two first electrode patterns 1113 on a printed circuit board 1210. In addition, two or more dummy patterns 1221 are also arranged in parallel with one another between two second electrode patterns 1123 on a flexible printed circuit board 1220. The dummy patterns of these respective printed circuit boards face to each other in a one-on-one relationship.

In the printed circuit board assembly 1200 of the present embodiment, when connecting the flexible printed circuit board 1220 to the printed circuit board 1210, an anisotropically conductive adhesive agent 1130 is also applied to the location of the above dummy patterns which are not related to any electrical function. In the present embodiment, however, the location on which the dummy patterns are formed is not supported by the backup plate 1160.

The location on which the dummy patterns are formed causes irregularities on the surface of the printed circuit board because of the presence of the dummy patterns. Such irregularities are responsible for an increase in adhesion area of the anisotropically conductive adhesive agent 1130 in this location. As a result, the adhesive strength of the flexible printed circuit board 1220 to the printed circuit board 1210 can be strengthened.

Each of the above plural printed circuit boards includes dummy patterns facing each other through the above adhesive agent. The dummy patterns are formed adjacent to the above electrode patterns on the surface of each printed circuit board.

Like the above first embodiment, it is noted that the fifth embodiment described above is able to mount the electronic component 1111 on the backside of the location of the printed circuit board 1210, to which the flexible printed circuit board 1220 is connected.

Next, a sixth embodiment will be described.

This sixth embodiment differs from the first embodiment with respect to the printed circuit board assembly. On the other hand, a mobile phone on which the printed circuit board assembly is mounted and the flow of processing in the method for connection of printed circuit boards are the same or similar to those of the above first embodiment, respectively. In the following description, therefore, the explanation about the mobile phone and the method for connection of printed circuit boards will be omitted, while particular attention will be directed toward the above differences.

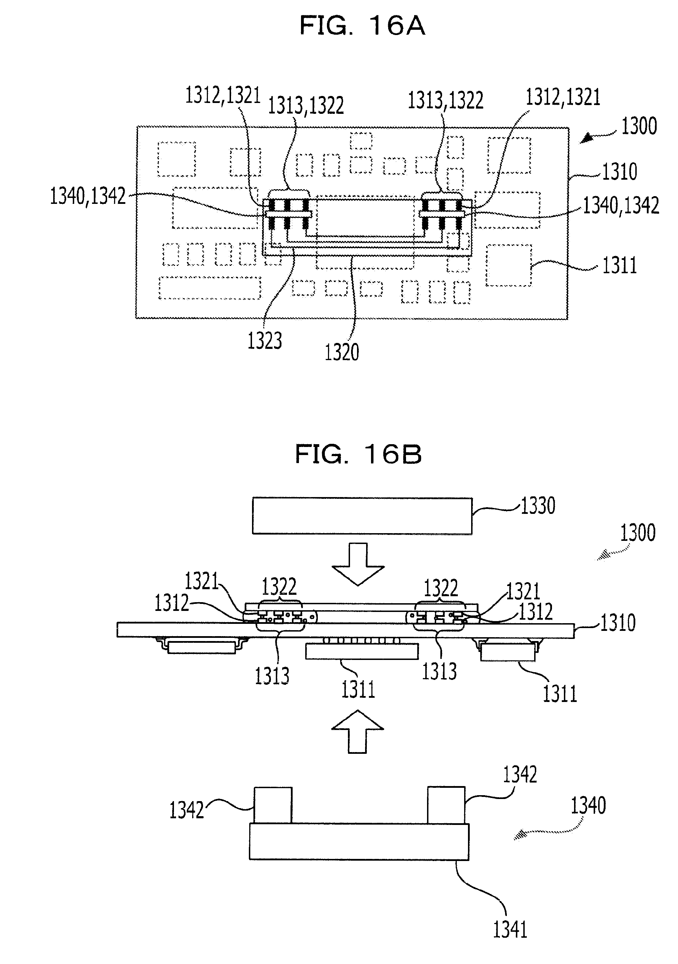

FIGs. 16A and 16B illustrate a printed circuit board assembly of a sixth embodiment.

Unlike the printed circuit board assembly of any of the embodiments described above, in the printed circuit board assembly 1300 of FIGs. 16A and 16B, a flexible printed circuit board 1320 is used for complementing part of the wiring of the printed circuit board 1310. FIG. 16A is a top view of the printed circuit board assembly 1300 viewed from the flexible printed circuit board 1320. In addition, FIG. 16B illustrates the side view of the printed circuit board assembly 1300.

In the present embodiment, on the surface of the printed circuit board 1310, a first electrode pattern 1313 is formed on each of two locations. The first electrode pattern 1313 is constructed of a plurality of conductor patterns 1312 which are linearly extended and arranged in parallel with each other. Then, each of the first electrode patterns 1313 is formed on the location corresponding to the space between electronic components 1311 mounted on the back surface of the area of the printed circuit board 1310, to which the flexible printed circuit board 1320 is connected.

The flexible printed circuit board 1320 has a length and a width sufficient to electrically connect two first electrode patterns 1313 on the printed circuit board 1310. Furthermore, on the surface of the flexible printed circuit board 1320, the following two second electrode patterns 1322 are formed. On the second electrode pattern 1322, plural conductive patterns 1321 are arranged in parallel with one another. These conductive patterns 1321 correspond to a plurality of conductive patterns 1312 of the above first electrode patterns 1313 in a one-on-one relationship. In addition, wiring patterns 1323 are formed in the inner layer of the flexible printed circuit board 1320 and connects the conductor patterns 1321 of two second electrode patterns 1322 to each other in a one-on-one relationship.

The flexible printed circuit board 1320 is overlapped on the printed circuit board 1310, while an anisotropically conductive adhesive agent 1330 is sandwiched between the flexible printed circuit board 1320 and the printed circuit board 1310. In this case, the conductor patterns 1321 of the second electrode pattern 1322 face the conductor patterns of the first electrode pattern 1313 in a one-on-one relationship. In addition, by pressing and heating using a pressing/heating plate 1330 and a backup plate 1340, the flexible printed circuit board 1320 is connected to the printed circuit board 1310. Here, the backup plate 1340 includes a flat base plate 1341 and two press-contact sections 1342. In addition, the press-contact sections 1342 are press-contacted to the backside of the first electrode pattern 1313 while avoiding contact with an electronic component 1311. Furthermore, each press-contact section 1342 has a width narrower than the length of the conductor patterns and extends in the direction closing the conductor patterns.

In this printed circuit board assembly 1300, connection is made between the conductor patterns 1321 of one first electrode pattern 1313 and the conductor patterns 1321 of the other first electrode pattern 1313 by the wiring patterns 1323 of the flexible printed circuit board 1320 in a one-on-one relationship. In other words, in the present embodiment, the printed circuit board assembly 1300 is used for complementing part of the wiring of the printed circuit board 1310. Such a configuration of the printed circuit board assembly 1300 of the present embodiment permits a decrease in wiring density in the printed circuit board 1310. As a result, an increase in cost due to multilayering of printed circuit boards and an increase in the entire thickness of the printed circuit board assembly 1300 can be avoided.

At least one of plural printed circuit boards includes wiring patterns that electrically connect the conductor patterns of electrode patterns in this printed circuit board.

Like the above first embodiment, it is noted that the sixth embodiment described above is able to mount the electronic component 1311 on the backside of the location of the printed circuit board 1310, to which the flexible printed circuit board 1320 is connected.

Furthermore, in any of the above embodiments, the mobile phone has been exemplified as a specific embodiment of an electronic device on which a printed circuit board assembly is mounted. However, the electronic device is not limited to a mobile phone. For example, the electronic device may be any mobile device other than a mobile phone, such as a laptop computer or a digital camera.

Also, in any of the above embodiments, the printed circuit board assembly constructed of two printed circuit boards, a rigid printed circuit board and a flexible printed circuit board, has been exemplified as a specific embodiment of the printed circuit board assembly. However, the printed circuit board assembly manufactured using this method for connection of printed circuit boards is not restricted to such kind of printed circuit board assembly. Alternatively, the printed circuit board assembly may be constructed of three or more printed circuit boards, for example, one rigid printed circuit board and two or more flexible printed circuit boards. Alternatively, it may include two rigid printed circuit boards.

In any of the above embodiments, the pressing/heating plate, which has been given as an example of the pressing/heating plate, is designed to press the printed circuit board (flexible printed circuit board) by its press surface that covers the entire area for connection of the printed circuit board. However, it is not limited to such kind of a pressing/heating plate. Alternatively, the pressing/heating plate may be designed to press the printed circuit board by its press surface that covers the minimum necessary section of the area for connection of the printed circuit board. Furthermore, on the printed circuit board, which is pressed by the pressing/heating plate, an electronic component may be mounted on a location away from the area to be pressed by the pressing/heating plate.

All examples and conditional language recited herein are intended for pedagogical objects to aid the reader in understanding the invention and the concepts contributed by the inventors to further the art, and are to be construed as being without limitation to such specifically recited examples and conditions, nor does the organization of such examples in the specification relate to a showing of the superiority and inferiority of the invention. Although the embodiments of the invention have been described in detail, it will be understood by those of ordinary skill in the relevant art that various changes, substitutions, and alterations could be made hereto without departing from the scope of the invention as set forth in the claims.

## Claims

1. A method for connection of a flexible circuit board to a rigid circuit board comprising:
supplying an adhesive agent onto a first electrode pattern provided on one surface of the rigid circuit board, the rigid circuit board including a plurality of electronic components mounted on the other surface with a gap therebetween;
aligning a second electrode pattern provided on the flexible circuit board to the first electrode pattern of the rigid circuit board;
heating under pressure the adhesive agent to electrically connect the second electrode pattern to the first electrode pattern by pressing the gap between the plurality of electronic components with a jig having a press-contact section of a narrower width than the gap.

2. The method for connection according to claim 1, wherein the press-contact location of the jig includes an elongated projection member having a width equal to or greater than the first electrode pattern of the rigid circuit board, and the gap of the plurality of electronic components is pressed by the elongated projection member.

3. The method for connection according to claim 1, wherein the press-contact section of the jig includes two or more projection members spaced one apart from another, and the gap of the plurality of electronic components is pressed by the projection members.

4. The method for connection according to claim 1, 2 or 3, wherein at least one of the first electrode pattern and the second electrode pattern includes a plurality of conductor patterns extending in parallel with one another.

5. The method for connection according to claim 4, wherein the conductor patterns of the first electrode pattern and the conductor patterns of the second electrode pattern are overlapped with each other in a one-on-one relationship.

6. The method for connection according to any preceding claim, wherein the gap between the adjacent electronic components in the plurality of electronic components mounted on one side of the first printed circuit board has a width narrower than the length of the conductor patterns of the first electrode pattern and is pressed by the press surface which extends longer than the width of the gap.

7. The method for connection according to any preceding claim, wherein the adhesive agent is an anisotropically conductive adhesive agent that includes conductive particles dispersed in thermosetting resin and exerts conductivity in a direction crossing an adhesive surface.

8. The method for connection according to claim 7, wherein the adhesive agent is cured by heating.

9. A device for connection of a flexible circuit board to a rigid circuit board comprising:
a first jig for holding the rigid circuit board thereon, the rigid circuit board including a first electrode pattern provided on one surface and a plurality of electronic components mounted on the other surface with a gap therebetween;
a second jig for pressing the flexible circuit board including a second electrode pattern to the rigid circuit board;
a supply mechanism for supplying an adhesive agent onto the first electrode pattern;
an alignment mechanism for aligning the second electrode pattern provided on the flexible circuit board to the first electrode pattern; and
a heating mechanism for heating the adhesive agent,
wherein the first jig includes a press-contact section having a narrower width than the gap to press the gap between the plurality of electronic components.

10. The device for connection according to claim 9, wherein the press-contact section of the jig includes an elongated projection member having a width equal to or greater than the first electrode pattern of the rigid circuit board, whereby the gap of the plurality of electronic components can be pressed by the elongated projection member.

11. The device for connection according to claim 9, wherein the press-contact section of the jig includes two or more projection members spaced one apart from another, whereby the gap of the plurality of electronic components can be pressed by the projection members.

12. A printed circuit board assembly, comprising:
a rigid circuit board including a first electrode pattern provided on one surface and a plurality of electronic components mounted on the other surface with a gap therebetween;
a flexible circuit board including a second electrode pattern aligned with the first electrode pattern; and
an adhesive agent interposed between the flexible circuit board and the rigid circuit board to electrically connect the first electrode pattern to the second electrode pattern,
wherein a bonding area within the first electrode pattern corresponds to the gap between the plurality of electronic components.

13. The printed circuit board assembly according to claim 12, wherein at least one of the first electrode pattern and the second electrode pattern includes a plurality of conductor patterns extending in parallel with one another.

14. The printed circuit board assembly according to claim 13, wherein the conductor patterns of the first electrode pattern and the conductor patterns of the second electrode pattern are overlapped with each other in a one-on-one relationship.

15. An electronic apparatus, comprising:
an enclosure; and
a printed circuit board assembly installed in the enclosure, wherein the printed circuit board assembly includes:
a rigid circuit board including a first electrode pattern provided on one surface and a plurality of electronic components mounted on the other surface with a gap therebetween;
a flexible circuit board including a second electrode pattern aligned with the first electrode pattern; and
an adhesive agent interposed between the flexible circuit board and the rigid circuit board to electrically connect the first electrode pattern to the second electrode pattern, wherein a bonding area within the first electrode pattern corresponds to the gap between the plurality of electronic components.
